# EUROPEAN PATENT SPECIFICATION

(11) **EP 1 861 924 B1**
(45) Date of publication and mention of the grant of the patent: **15.12.2010**
(21) Application number: 06717125.6
(22) Date of filing: 23.03.2006
(51) Int. Cl.: H03H 3/02, H01L 41/24, C23C 14/22

(54) **PIEZOELECTRIC THIN FILM RESONATOR AND METHOD FOR MAKING SAME**
PIEZOELEKTRISCHER DÜNNFILMRESONATOR UND VERFAHREN ZU SEINER HERSTELLUNG
RESONATEUR PIEZO-ELECTRIQUE EN COUCHES MINCES ET PROCEDE DE FABRICATION

(30) Priority: 23.03.2005 SE 0500647
(43) Date of publication of application: 05.12.2007
(73) Proprietor: RADI MEDICAL SYSTEMS AB, 754 50 Uppsala (SE)
(72) Inventor: KATARDJIEV, Ilia, S-756 47 Uppsala (SE); WINGQVIST, Gunilla, S-756 48 Uppsala (SE); BJURSTRÖM, Johan, S-752 58 Uppsala (SE)
(74) Representative: Holmberg, Nils Anders Patrik
(86) International application number: PCT/SE2006/050041
(87) International publication number: WO 2006/101450

(56) References cited:
- US-A- 3 558 351
- US-A- 4 719 383
- RODRIGUEZ-NAVARRO A ET AL: "Development of preferred orientation in polycrystalline AlN thin films deposited by rf sputtering system at low temperature" JOURNAL OF MATERIALS RESEARCH MATER. RES. SOC USA, vol. 12, no. 7, July 1997 (1997-07), pages 1850-1855, XP002545157 ISSN: 0884-2914

## Description

The present invention relates to a method of producing a polycrystalline film of AlN or ZnO for shear mode piezoelectric thin film resonators, such as biosensors or pressure sensor, e.g. in-vivo pressure sensors, especially for use in a liquid medium for mass loading and/or viscosity measurements and/or pressure measurements.

### Background

Deposition processes for highly textured (c-axis oriented) thin AlN or ZnO films have recently been developed by a number of companies for the fabrication of high frequency electroacoustic devices, most notably resonators, bandpass filters, etc using both longitudinal bulk and surface acoustic modes. A preferred method of film deposition is reactive sputtering since it is characterized by excellent uniformity as well as sufficiently high deposition rates. In the majority of cases, highly c-axis oriented films are desired to optimize both the electromechanical coupling kₜ and the Q value of the device. The degree of orientation is normally quantified by the full width half maximum (FWHM) value of the rocking curve corresponding to the (0002) X-ray diffraction (XRD) peak. Small FWHM values indicate highly oriented crystallites with the c-axis being almost normal to the surface, resulting in improved device performance since such devices normally utilize the thickness excited longitudinal mode. The latter exhibits a maximum electroacoustic coupling when the c-axis is parallel to the direction of wave propagation and at the same time parallel to the polarization (particle displacement), i.e. when the c-axis is normal to the film surface. A typical example of such devices is the thin film bulk acoustic resonator (FBAR).

Gas sensors based on the FBAR are readily fabricated since the loss in Q of the longitudinal mode when the resonator is in contact with a gas is sufficiently small.

When such a FBAR is in contact with a liquid, however, Q decreases by more than an order of magnitude due to acoustic leakage into the liquid. In such cases it is desirable to utilize the thickness excited shear mode which exhibits acceptable (low) losses in Q when in contact with a liquid. C-axis textured films are not suitable for this type of resonator, since the electromechanical coupling of the shear mode is practically zero for well oriented films. In such cases, the c-axis of the AlN films must exhibit a non-zero mean tilt relative to the surface normal, which will allow the excitation of the quasi-shear mode [N.F. Foster, et al, IEEE Trans. on Sonics and Ultrasonics, Vol. SU-15, No.1, Jan. 1968, p.28] in such films and hence making the latter suitable for the fabrication of biosensors operating in liquid media.

Wang et al [US patent 4,719,383] have developed a method for the deposition of such tilted ZnO and AlN films by applying an additional electric field which is thought to promote tilted c-axis film growth during reactive sputter deposition. Thus, this method requires a specific hardware alteration of a standard reactive sputter system. Further, the additional ion bombardment of the growing film results in highly compressive stresses causing plate bowing for films thinner than 3 µm as reported by the authors.

Attempts have also been made to sputter deposit c-axis tilted ZnO films by placing the substrate at a 90° angle with respect to the plane of the target [M.Minakata et al., Japan. J. Appl. Phys. Vol. 12, 1973, p. 474]. This method, however, suffers from poor thickness and functional uniformity.

US3558351 discloses a two step sputtering method for deposition of C-axis oriented ZnO films. The first nucleation step takes place in the presence of a hydrocarbon gas, and the second step (growth) takes place without the hydrocarbon gas but with the substrate tilted with respect to the target.

### Description of the invention

The present invention relates to shear mode piezoelectric thin film resonators and in particular to a method of producing the thin piezoelectric film included therein. The method comprises deposition of thin piezoelectric films with a non-zero mean tilt of the c-axis relative to the film normal. The deposition is done in a standard reactive magnetron sputter deposition system without any hardware modifications.

Most generally, the method consists of a two stage deposition process in the case where the surface onto which the piezoelectric film is to be deposited lacks a suitable crystallographic structure or alternatively roughness. Normally this surface is the surface of a conducting thin film serving as a bottom electrode in a device and which film together with a carrier wafer onto which it is grown comprise the substrate for the film growth. In cases where a bottom electrode is not needed, the carrier wafer itself represents the substrate. In the first stage (so called nucleation stage) deposition of the material is done under conditions where the sputtered atoms experience substantial gas phase collisions causing thermalization and randomization of the deposition flux. Thus, the film growth is said to be kinetically limited due to the limited surface diffusivity resulting from the relatively low kinetic energy of the condensing species. This results in a film with a relatively low texture, that is, it consists of small crystallites having a relatively broad crystallographic distribution.

During the second stage, which is used for all embodiments of the invention, the deposition process is operated under conditions reducing significantly gas phase collisions, which gives rise to two effects. The first one is that the deposition flux at any particular point on a substrate is directional (or anisotropic) arising from the asymmetry in the deposition flux emanated from the circular racetrack and received at the point under consideration. This, of course, is not valid for a small exclusion zone in the center of the substrate. The second effect is that the sputtered particles retain most of their original energy, which is of the order of half of the sublimation energy of the target material, and which energy is favorable for enhancing surface diffusion and subsequently crystal growth. The latter now proceeds under competitive growth conditions where crystallographic planes exhibiting relatively high surface binding energies as well as receiving largest flux, grow fastest. The resulting piezoelectric film has a distinct tilted texture with the mean tilt of the c-axis varying roughly in the interval 28 to 32 degrees over the substrate excluding a small exclusion zone in the center of the latter. The mean tilt angle distribution over the substrate has a circular symmetry.

In a different method, the first stage of the process may be omitted provided the substrate surface, has properties inhibiting (002) growth normal to the surface. This, for instance, may be a surface lacking hexagonal symmetry (assuming that the piezoelectric film has such a symmetry) or the surface has a sufficient microroughness which in turn promotes preferred crystallite growth along the net flux direction.

In either case, the resulting film has a pronounced tilted structure and is shown to have adequate properties for resonator operation in liquids.

Thus, the invention is directed to a method of producing a polycrystalline film of a metal compound, having specifically a wurtzite crystallographic structure such as AlN ZnO, BeO, BN, AlBN, etc on a substrate with a mean non-zero tilt of the c-axis relative to the surface normal of the substrate, the substrate comprising a carrier wafer with an optional electrode film deposited onto it, comprising the steps of depositing crystallites of said compound onto the substrate that has a suitable surface for crystal growth with tilted c-axis relative to the surface normal of the substrate by operating a deposition system designed for sputtering of atoms from a target comprising the metal of the compound, in a gas mixture atmosphere comprising an inert gas and nitrogen or oxygen, respectively, at a process pressure such that the mean free path of sputtered metal atoms is comparable or larger than the target to the substrate distance, the geometry of the deposition system being such that there exists at least one arbitrary area on the substrate where the distribution of the depositing flux is asymmetric relative to the surface normal at that area.

The target comprising the metal of the compound may be composed of the metal as such or of the metal compound itself.

The proportion of inert gas, such as argon, in the gas mixture is not critical as long as there is sufficient reactive gas, i.e. nitrogen or oxygen, present in the gas mixture atmosphere for growing a stoichiometric compound.

In an embodiment of the invention the metal compound is AlN, and in another embodiment it is ZnO, or BN, or BeO, or AlBN.

In a preferred embodiment of the method of the invention the substrate that has a suitable surface for crystal growth with tilted c-axis relative to the surface normal of the substrate is selected from the group consisting of
a) a substrate having a surface crystal structure lacking a hexagonal symmetry, such as Molybdenum , Aluminum, Platinum, Tungsten, or Tantalum.
b) a substrate having a surface crystal structure similar to that of any particular AlN crystal face other than the c-face,
c) a substrate having a non-zero surface micro-roughness,
d) a substrate onto which a very thin polycrystalline film of less than 200 nm thickness and a relatively low degree of texture is deposited, and
e) a substrate onto which an arbitrary but very thin amorphous film of less than 200 nm thickness is deposited and having a non-zero surface micro-roughness.

The randomly textured polycrystalline film in d) is preferably an AlN film or a ZnO film.

The non-zero micro-roughness surface in c) is preferably obtained by etching or polishing unless it already has this property as grown (a priori).

The present invention is also directed to a piezoelectric shear wave resonator comprising a polycrystalline film of a metal compound, selected from the group consisting of AlN and ZnO, produced by the method of the invention, and at least two electrodes in proximity to the film to provide excitation means.

In an embodiment the piezoelectric shear wave resonator of the invention is for use in a liquid medium for mass loading and/or viscosity measurements and/or pressure measurements, e.g. for use as a biosensor or a pressure sensor.

### Description of the drawings

Figure 1a. Schematic illustration of an arbitrary substrate with a relatively smooth surface, AlN nuclei with varying orientation of the c-axis relative to the surface normal and direction of the c-axis of an arbitrary nucleus.
Figure 1b. Schematic illustration of initial film growth onto a substrate, surface with a relatively small microroughness.
Figure 2. Schematic illustration of the anisotropy of the deposition flux under collisionless deposition conditions from a finite target.
Figure 3. Psi XRD diffractograms of the c-plane of an AlN film taken at equidistant positions on a 10 cm (4 inch) substrate, starting from center (curve 1) and ending at the edge (curve 7).
Figure 4. Geometry of the XRD [ψ,Y] scan. Note that the intersection line between the analytical plane D and the substrate plane S is always perpendicular to the Y-axis.
Figure 5. A SEM micrograph of an AlN film with a non-zero mean tilt of the c-axis relative to the film normal, grown under the conditions in Example I.
Figure 6. Schematic illustration of a shear wave FBAR resonator together with a microfluidic transport system.
Figure 7. Typical behavior of the impedance magnitude and phase of a shear wave resonator when the bottom electrode is in contact with pure water.
Figure 8a. The near resonance behavior of the conductance of a shear wave resonator when the bottom electrode is in contact with various concentrations of glycerol.
Figure 8b. Series resonance shift of a shear wave resonator when the bottom electrode is in contact with various concentrations of glycerol, measured relative to the resonance frequency in pure water.
Figure 9 schematically illustrates a spirally shaped blind used in connection with the present invention.
Figure 10 schematically illustrates an array of rectangular magnetrons applicable to be used in connection with the present invention.

### Detailed description

The following is a detailed description of a preferred embodiment of the present invention. Other embodiments will be readily apparent to those skilled in the art.

The method of the present invention for depositing thin film piezoelectric materials suitable for use as a thickness excited piezoelectric acoustic shear wave resonator will be described with reference to the drawings. The resonator comprises a piezoelectric film of a material having 6 mm symmetry as well as two electrodes on either side of the film in intimate contact with the latter. The c-axis of the piezoelectric film exhibits a non-zero mean tilt with respect to the normal to the film surface.

By the method of the invention, the piezoelectric film is sputter deposited in a standard reactive planar magnetron sputtering system where an Al or AlN target is sputtered in a gas mixture of an inert gas (e.g. Ar) and nitrogen while the sputtered flux is condensed onto a substrate. The discharge can be any of the following three types, direct current (DC), pulsed DC or radio frequency (RF). The magnetic field configuration can be both balanced or unbalanced.

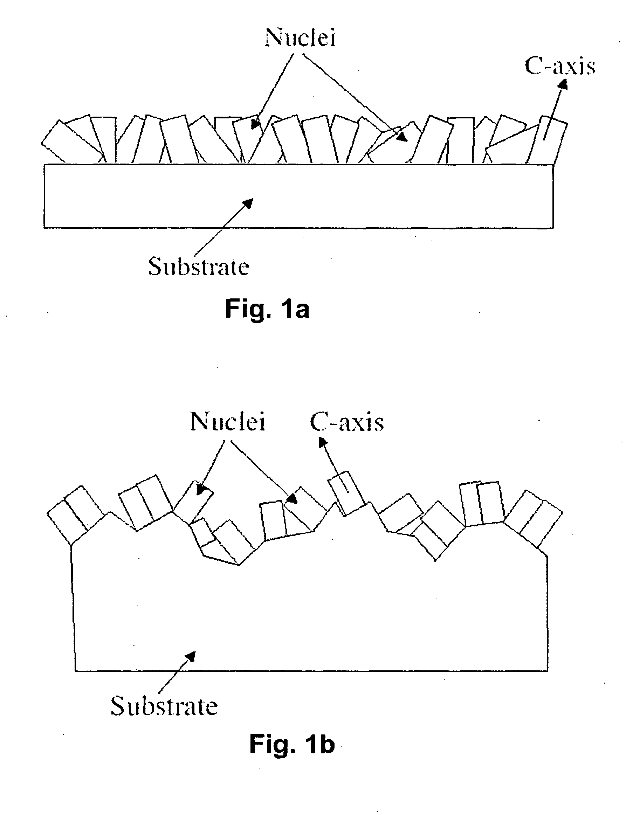

Unique to the method of the present invention is the two stage deposition process, nucleation and growth stages, respectively. The purpose of the first stage is to nucleate, or alternatively to create conditions for the nucleation of, crystal cones (columns) with a tilted c-axis relative to the surface normal. This can be done in a variety of ways as illustrated in the examples below. At this stage there exists no particular preferred nuclei orientation, rather than all orientations may be possible as illustrated schematically in Figure 1a,b.

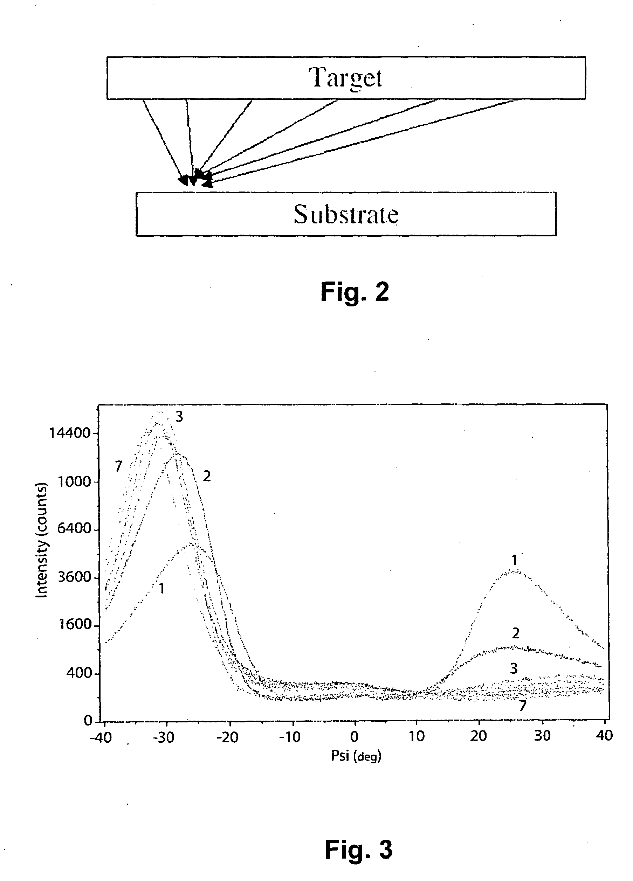

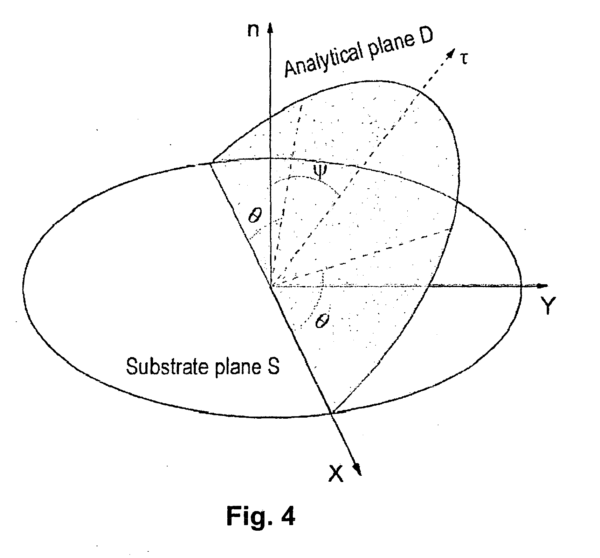

During the second stage, crystallite growth at any particular area on the substrate proceeds predominantly along the direction of the mean flux, the latter being defined as the vector sum of all individual fluxes emanated at all elementary areas on the target surface and received at the substrate, i.e. substrate, area in question as illustrated in Figure 2. It is clear for the skilled in the art that for a finite target the mean flux distribution is asymmetric for all points on the substrate except in the center of the substrate, provided that no significant scattering of the sputtered flux takes place in the gas phase. For this purpose and to avoid scattering of the sputtered flux in the gas phase, the process pressure during the second stage is kept at values such that the mean free path of the sputtered atoms is comparable or larger than the target-to-substrate distance. Under these conditions the film growth process proceeds in the so called competitive growth regime, that is, cones receiving largest flux grow fastest. Naturally, these are the cones aligned approximately with the mean flux direction at the point under consideration. It is also evident from symmetry considerations that the mean flux direction and hence the film tilt will vary across the radius of the substrate, that is, the mean tilt of the c-axis will be zero at the center of the substrate while being maximum at the edges of the substrate. This is demonstrated in Figure 3 which shows a series of [ψ, Y] X-ray diffraction (XRD) scans of the (002) plane of AlN films grown under the conditions described in Example I below. The XRD scans are numbered from 1 to 7 and represent different diffractograms taken at equidistant positions "Y" along the radius of the 10 cm Si wafer (Y-axis) starting from the center to the edge of the latter, respectively. The measurement geometry is shown in Figure 4. Specifically, D denotes the analytical plane defined by the incident and diffracted beam, the vector "τ" is the bisector of the angle between the latter two beams, while 0 is the incident beam angle fixed at 18.02° which corresponds to the (002) crystallographic plane of AlN. Finally, the vector "τ" is scanned in the plane defined by the film normal "n" and the Y-axis and hence the angle "ψ" is the angle between the vector "τ" and the film normal "n". Under these conditions we are measuring the c-axis distribution in the plane defined by the Y-axis and the normal "n" to the film surface at any particular point along the Y-axis. Specifically, curve 1, corresponding to a measurement taken at the center of the wafer, exhibits two symmetric distributions at angles around ±26° reflecting the fact that the distribution of the deposition flux at the center of the wafer is symmetric and hence no net tilt in the film is observed. This situation changes drastically for off-center measurement (curves 2 through to 7) for which the peak at around 26° diminishes rapidly while exhibiting a very distinct peak in the range from -28 to -32°. These results indicate that at off-center positions the c-axis of the AlN film exhibits a net tilt such that the inclination points towards the center of the wafer (circular symmetry). Note that the variation of the mean tilt over the wafer lies in a very narrow angular interval (from -28 to -32°) indicating good functional uniformity of the films excluding a small central zone. This small angular range indicates also that the film exhibits predominantly a (103) texture since the latter direction makes an angle of about 28° relative to the surface normal.

Thus, the preferred mean tilt lies in the range from 28 to 32°, but a broader mean tilt range of 10 to 50° have also been shown to be applicable when embodying the present invention.

### Example I

A target of 99,999% pure Al, 15 cm (6 inch) in diameter, was sputtered in a pulsed DC planar magnetron sputtering system Von Ardenne-CS 730. No modifications to the latter were made. A standard highly polished 10 cm (100) Si wafer was placed onto the wafer holder such that the wafer surface was parallel to that of the target and the wafer centered directly under the target. The distance between the wafer and the Al target was about 5.5 cm. No external heating of the wafer holder was applied.

Initially, the discharge was operated in a 99,999% pure Ar atmosphere at a process pressure of 0.7 Pa, gas flow of 100 cm³/min (sccm) and a discharge power of 1000W for a period of 1 minute resulting in an Al electrode film of thickness 200nm. The substrate was then taken out of the chamber and the Al electrode film was then patterned to define the bottom electrode geometry using a standard optical lithography process followed by subsequent dry etching in a fluorine based plasma. The resist was then stripped in a standard oxygen plasma reactor. The Al electrode film had a (111) texture with a FWHM of the rocking curve of about 1.6 degrees.

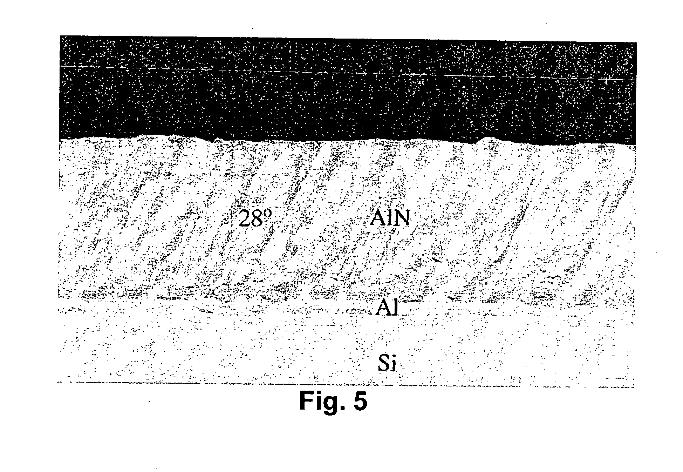

The substrate, i.e. the thus deposited Al electrode film together with the Si wafer, was reinserted into its original position in the process chamber. The discharge was then operated in a mixture of 99,999% pure nitrogen (45 cm³/min (sccm)) and 99,999% argon (15 cm³/min (sccm)), and a discharge power of 1200W. Initially, during the nucleation stage (stage 1) the discharge was operated at a process pressure of 2.66 Pa for a period of 5 minutes resulting in a seed layer with a thickness of about 100 nm. Since the mean free path at this pressure is much smaller than the target-to-substrate distance, the sputtered Al atoms experience multiple scattering collisions in the gas phase resulting in a more or less isotropic deposition flux at the substrate surface (i.e. no preferred flux direction). In addition, the sputtered Al atoms are thermalized as a consequence of the scattering process so that when condensing onto the substrate surface they have an effective temperature approximately equal to that of the surrounding gas. Under these conditions the growth process is diffusion limited resulting in a film with an almost random crystallographic texture resembling that shown in Figure 1a. At this point the process pressure is decreased down to 0.266 Pa creating thus suitable conditions for stage 2 of the process, that is, the deposition flux is generally anisotropic at the substrate surface (excluding the center area). In addition, the Al atoms retain most of their original energy which they eventually deposit at the surface enhancing thus surface diffusion and hence resulting in films with good crystalline quality. The deposition rate at this stage is about 3.6 µm/hour and the process is operated for 33 minutes. No external bias was applied to the wafer holder during any of the two stages of the AlN deposition process. Figure 5 shows a SEM micrograph of the resulting AlN film taken half way between the center and the edge of the substrate. The top electrode is then defined in an identical manner as the bottom one.

### Example II

A target of 99,999% pure Mo, 15 cm in diameter, was sputtered in a pulsed DC planar magnetron sputtering system Von Ardenne-CS 730. Si wafers as in Example I were used. The discharge was operated in a 99,999% pure Ar atmosphere at a process pressure of 0.8 Pa and a discharge power of 1000W for a period of 5 minutes resulting in a Mo electrode film of thickness 200nm and (110) texture with a FWHM of the (110) rocking curve of about 5 degrees. The Mo electrode film is then sputtered in an Ar plasma and an Ar pressure of 2.66 Pa by applying a 100 W RF power to the wafer holder for a duration of 5 minutes. This mild sputtering of the deposited Mo electrode film results in increasing the surface microroughness, schematically shown in Figure 1b. After patterning the Mo electrode film, the process then proceeded directly with stage 2 as described in Example I.

Owing to the microroughness of the Mo electrode film thus achieved, both the nucleation and the growth of the AlN film take place predominantly in the direction of the deposition flux at any particular area on the substrate resulting in a tilted c-axis film growth.

### Example III

A target of 99,999% pure tungsten, 15 cm in diameter, was sputtered in a pulsed DC planar magnetron sputtering system Von Ardenne-CS 730. Si wafers as in Example I were used. The discharge was operated in a 99,999% pure Ar atmosphere at a process pressure of 0.8 Pa and a discharge power of 1000W for a period of 1 minute resulting in a W electrode film of thickness 200nm. Under these conditions the W electrode film has a rather smooth surface (a r.m.s. value in the order of 5 to 10nm). The texture of the W electrode film was (110) with a rather large FWHM of the (110) rocking curve in the range 6 to 10 degrees. After patterning the W electrode film, the process then proceeded directly with stage 2 as described in Example I. Owing to the relatively poor texture of the W electrode film as defined by the FWHM of the (110) rocking curve both the nucleation and the growth of the AlN film take place predominantly in the direction of the deposition flux at any particular area on the substrate resulting in a tilted c-axis film growth.

The foregoing examples are intended for illustration and are not intended to limit the choice of materials or sputter deposition parameters or deposition geometry comprised by the scope of the present invention. For example, ZnO can equally well be used instead of AlN, in which case a Zn or a ZnO target will be sputtered in an oxygen containing atmosphere. Analogously, the method equally applies to BN, BeO AlBN, AlGaN, and in fact all similar materials having a wurtzite crystallographic structure.

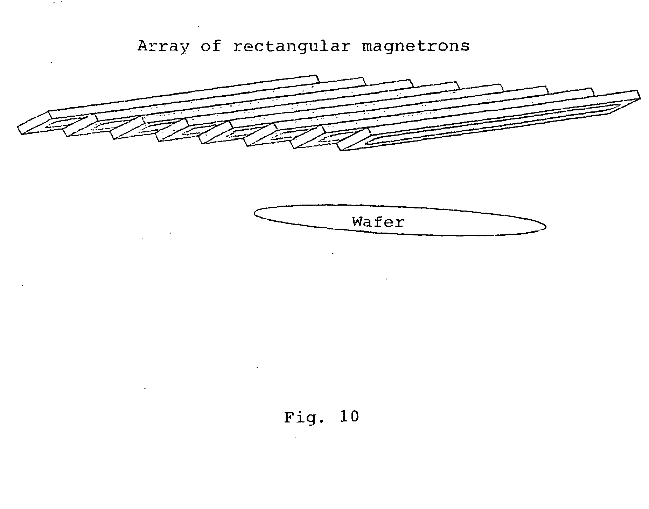

The method disclosed inhere refers primarily to circular targets but for those skilled in the art it is obvious that the method is readily adapted to any other shape or form of the target such as linear magnetrons or even multiple magnetrons. A specific example could be the use of an array of mutually parallel linear magnetrons (see figure 10) which are arranged in a plane parallel to that of the substrate but the normal to the surface of which magnetrons forms a non-zero angle with the normal to the substrate surface. Obviously in this case the tilt of the resulting film will have a planar symmetry.

The carrier wafer type is immaterial to the invention as it acts as a physical carrier, and hence any other carrier wafer, such as glass, etc, with a sufficient surface smoothness can be used. In specific cases, however, its crystallographic surface structure may play an important role in achieving the required crystallographic properties of the bottom electrode film.

Deposition parameters, such as substrate temperature, discharge power, electrode and magnetic field geometry, substrate bias, gas composition, etc may also be varied for further optimization of film properties, such as density, surface smoothness, stress, degree of inclination, film uniformity, etc, as is well known in the art of sputtering. Post deposition annealing may also be applied.

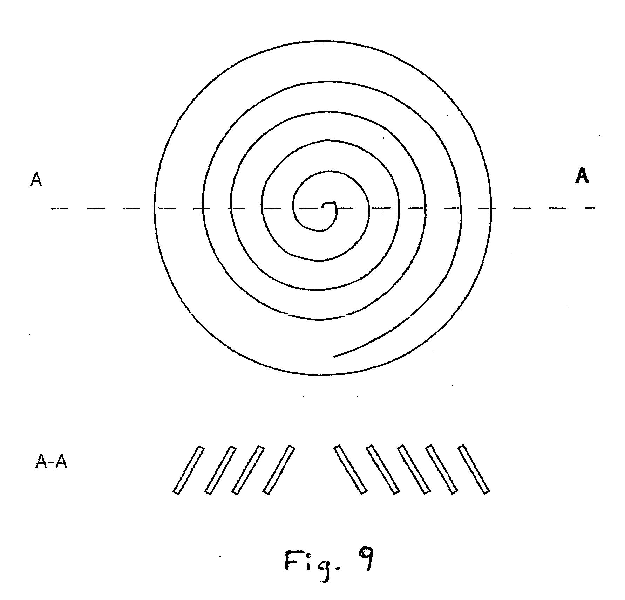

A key element of the present invention is the texture of the seed layer. As stated above, the seed layer deposited during stage I of the process has more or less a random texture. This condition is needed to guarantee that at every point on the substrate surface there is a nucleus with a suitable orientation of the c-axis which is more or less aligned with the flux direction at that point. Ideally however, the texture of the seed layer should have a preferred texture (say (103) in the case of AlN) with a circular symmetry, such that the nuclei have their c-axis tilted towards the center of the wafer under one and the same angle. Thus, such a texture of the seed layer, where the c-axis of the nuclei is roughly aligned with the mean flux direction at every point on the substrate, is most suitable for the growth during stage II of the process. In this context it is obvious to those skilled in the art that improvements of the texture of the seed layer can readily be done by optimizing the deposition parameters as well as by modifying the deposition geometry. A specific example of the latter is the introduction of a focusing system consisting, say, of a spirally shaped blind (see figure 9), the blade of which is titled under a specific angle towards the center of the wafer, and which system enhances the directionality of the deposition flux at the every point on the substrate surface, thus promoting growth of the desired texture of the seed layer while prohibiting (002) growth at the same time. A relative rotational motion between the blind and the substrate then guarantees a good thickness uniformity of the seed layer.

Essential features of the present invention, as explained above, are two main elements, the properties of the interface between the bottom electrode film and the piezoelectric film (i.e. the seed surface or alternatively the seed layer) as well as the directionality of the deposition flux at the substrate surface. With respect to the first of these two elements, the surface of the bottom electrode film has to have a relatively poor crystallographic texture and/or have a relatively high surface roughness and/or lack a hexagonal symmetry. Further, the bottom electrode film may even consist of more than one layer, provided the top layer satisfies at least one of the above surface requirements. If none of these requirements is satisfied, then a thin seed layer that satisfies some or all of these surface requirements is first deposited onto the substrate (as in Example I above). The thickness of this seed layer may also be varied for optimal results. This, in fact, is the preferred embodiment of the present invention since in this case the deposition process is completely independent of the properties of underlying material, i.e. the bottom electrode film or the carrier wafer in cases where the latter is omitted.

Once a favorable nucleation surface is established, tilted growth is achieved through the directionality of the deposition flux at the wafer surface. This directionality is guaranteed by the process pressure, which is such that the mean free path of the sputtered particles is comparable or larger than the substrate-to-target distance. In this context both the process pressure and the substrate-to-target distance may be varied as is known in the art of sputtering as long as the mean free path criterion is satisfied. Further modifications may readily be done by optimizing the radius of the so called race track on the target by modifying the magnetic field configuration in view of reducing the exclusion zone at the center of the wafer as well as optimizing the structural and thickness uniformity of the piezoelectric film.

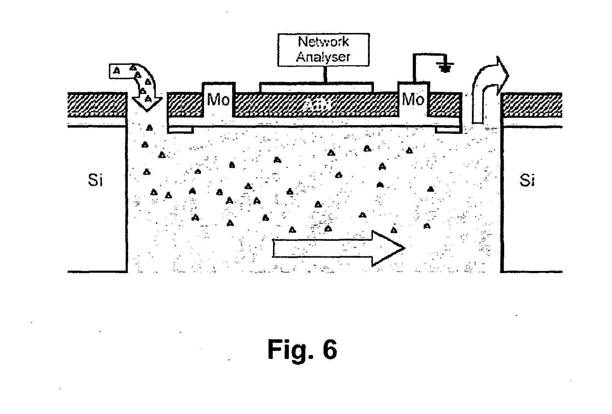

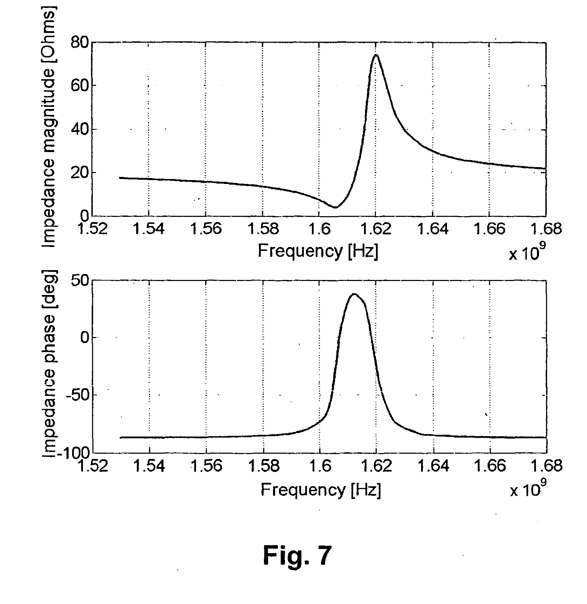

The topology of the piezoelectric shear wave resonator and its acoustic isolation from the substrate are not essential to the present invention and will not be described in detail. However, a typical piezoelectric shear wave resonator according to the present invention comprises a film of piezoelectric material, i.e. AlN or ZnO or generally a material having a wurtzite structure (based on the hexagonal close packed lattice, where every other atom is A or B, for example GaN), having its c-axis tilted with respect to the film normal, and at least two electrodes in proximity thereto to provide excitation means as illustrated schematically in Fig. 6. The design of such resonators is well known and can be found in a number of publications [a) K.M. Lakin, J.S. Wang, G.R. Kline, A.R. Landin, Y.Y. Chen and J.D. Hunt, Thin Film Resonators and Filters, IEEE Ultrasonic Symposium, 1982, page 466; b) European patent: EP 1 041 717 A2, 04.10.2000, J.D. Larson, R.C. Ruby, P. Bradley, Agilent Technologies Inc, Palo Alto, CA 94306-2024 (US)]. In here we have used a resonator of membrane type next to which we have defined microfluidic channels in the Si carrier wafer for transporting the liquid analyte into the cavity under the grounded Mo bottom electrode. As an analyte for this demonstration we have used an aqueous solution of glycerol at various concentrations. Figure 7 shows the near resonance impedance and its phase of a typical resonator when the bottom electrode is in contact with water. The series Q value in this case is about 170.

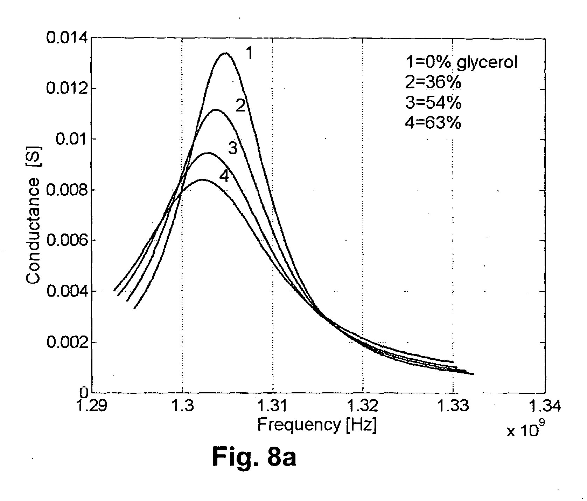

Figure 8a shows the near resonance conductance of a resonator when the bottom electrode is in contact with four different concentrations of glycerol. It is noted that in this case an additional Au layer was deposited on the back side of the bottom electrode in view of further studies.

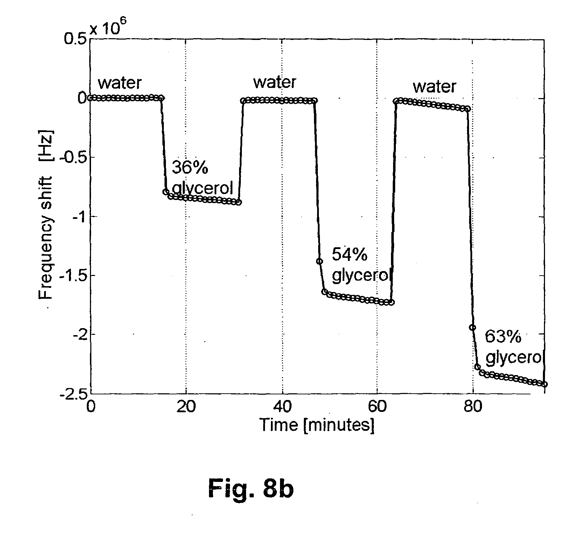

Figure 8b shows the corresponding resonance frequency shift relative to the resonance in pure water where the x-axis denotes time intervals at which subsequent measurements are taken. The latter were done at room temperature without any compensation for temperature fluctuations. The temperature coefficient of the resonator was found to be -25 ppm/°C in the range of 20 °C to 100 °C.

## Claims

1. A method of producing a polycrystalline film of a metal compound, selected from the group consisting of AlN and ZnO and wurtzite structure metal compounds, on a substrate with a mean non-zero tilt of the c-axis relative to the surface normal of the substrate, the substrate comprising a carrier wafer and has a surface for crystal growth with tilted c-axis relative to the surface normal of the substrate,
the method comprises the steps:
i) a nucleation step, performed by depositing crystallites of said compound onto the substrate in order to nucleate, or to create conditions for the nucleation of, crystal cones with a tilted c-axis relative to the surface normal, wherein the nucleation step is performed under conditions where the sputtered atoms experience substantial gas phase collisions causing thermalization and randomization of the deposition flux, and
ii) a growth step, performed by depositing atoms from the metal compound onto the crystallites to obtain said polycrystalline film, wherein the growth step is performed under conditions reducing gas phase collisions, causing that the deposition flux at any particular point on the substrate is directional.

2. The method according to claim 1, wherein the growth step is performed by operating a deposition system designed for sputtering of atoms from a target comprising the metal of the compound.

3. The method according to claim 2, wherein said sputtering is performed in a gas mixture atmosphere comprising an inert gas and nitrogen or oxygen, respectively, at a process pressure such that the mean free path of sputtered metal atoms is comparable or larger than the target to the substrate distance.

4. The method according to claim 3, wherein the geometry of the deposition system being such that there exists at least one arbitrary area on the substrate where the distribution of the depositing flux is asymmetric relative to the surface normal at that area.

5. The method according to claim 1, wherein the metal compound having a wurtzite structure is selected from the group consisting of SnO, BN, BeO, AlBN, AlGaN.

6. The method according to any one of the claims 1 - 5, wherein the substrate that has a surface for crystal growth with tilted c-axis relative to the surface normal of the substrate is selected from the group consisting of
a) a substrate that has a surface crystal structure lacking a hexagonal symmetry , such as Molybdenum, Aluminum, Platinum, Tungsten, or Tantalum.
b) a substrate that has a surface crystal structure similar to that of any particular AlN crystal face other than the c-face,
c) a substrate that has a non-zero surface micro-roughness,
d) a substrate onto which a very thin polycrystalline film of less than 200 nm thickness and a relatively low degree of texture is deposited,
e) a substrate onto which a very thin polycrystalline film of less than 200 nm thickness and having a preferred non-(002) texture with circular symmetry is deposited, and
f) a substrate onto which an arbitrary but very thin amorphous film of less than 200 nm thickness is deposited and having a non-zero surface micro-roughness.

7. The method according to claim 6, wherein the thin polycrystalline film in d) and e) is an AlN film.

8. The method according to claim 6, wherein the thin polycrystalline film in d) and e) is a ZnO film.

9. The method according to claim 6, wherein the thin polycrystalline film in d) and e) is a wurtzite structure metal compound film.

10. The method according to claim 6, wherein the thin polycrystalline film in e) is deposited through a spirally shaped blind, the blade of which is titled under a specific angle towards the center of the wafer.

11. The method according to claim 10, wherein the blind is centered directly over the substrate and is in relative rotational motion with the substrate.

12. The method according to claim 6, wherein the non-zero micro-roughness surface in c) is obtained by etching or polishing.

13. A piezoelectric shear wave resonator comprising a polycrystalline film of a metal compound, selected from the group consisting of AlN and ZnO and wurtzite structure metal compounds, produced by the method according to any one of claims 1 - 12.

14. A piezoelectric shear wave resonator according to claim 13, comprising at least two electrodes in proximity to the film to provide excitation means.

15. The piezoelectric shear wave resonator according to claim 13 or 14, for use in a liquid medium for mass loading and/or viscosity measurements and/or pressure measurements.

16. The piezoelectric shear wave resonator according to claim 13 or 14, for use as a biosensor and/or pressure sensor.

17. A piezoelectric shear wave resonator comprising a polycrystalline film of a metal compound with a mean non-zero tilt of the c-axis relative to a surface normal of a substrate, the resonator being produced by the method according to any one of claims 1 - 12.

18. A piezoelectric shear wave resonator according to claim 17, wherein the piezoelectric film has a distinct tilted texture with the mean tilt of the c-axis varying roughly in the interval 10 to 50 degrees over the substrate.

19. A piezoelectric shear wave resonator according to claim 18, wherein the piezoelectric film has a distinct tilted texture with the mean tilt of the c-axis varying roughly in the interval 28 to 32 degrees over the substrate.

20. In-vivo pressure sensor comprising a piezoelectric shear wave resonator according to claim 15 or 16, or produced according to any of claims 1-12.

## Patentansprüche

1. Verfahren zum Herstellen eines polykristallinen Films aus einer Metallverbindung, ausgewählt aus der Gruppe bestehend aus AlN und ZnO und Wurtzit-Struktur-Metallverbindungen, auf einem Substrat mit einer mittleren, von null verschiedenen Neigung der c-Achse relativ zu der Oberflächennormalen des Substrats, wobei das Substrat einen Trägerwafer umfasst und eine Oberfläche aufweist für Kristallwachstum mit geneigter c-Achse relativ zu der Oberflächennormalen des Substrats,
wobei das Verfahren die folgenden Schritte umfasst:
i) einen Nukleierungsschritt, ausgeführt durch Abscheiden von Kristalliten der Verbindung auf dem Substrat zum Nukleieren oder zum Herstellen von Bedingungen für die Nukleierung von Kristallkegeln mit einer geneigten c-Achse relativ zu der Oberflächennormalen, wobei der Nukleierungsschritt unter Bedingungen durchgeführt wird, wo die gesputterten Atome substantielle Gasphasenkollisionen erfahren, was eine Thermalisierung und Randomisierung des Abscheidungsflusses verursacht,
und
ii) einen Wachstumsschritt, durchgeführt durch Abscheiden von Atomen aus der Metallverbindung auf den Kristalliten, um den polykristallinen Film zu erhalten, wobei der Wachstumsschritt unter Bedingungen durchgeführt wird, die Gasphasenkollisionen reduzieren, was bewirkt, dass der Abscheidungsfluss an einem beliebigen jeweiligen Punkt auf dem Substrat gerichtet ist.

2. Verfahren nach Anspruch 1, wobei der Wachstumsschritt durchgeführt wird durch Betreiben eines Abscheidungssystems, das ausgelegt ist zum Sputtern von Atomen aus einem Target, das das Metall der Verbindung umfasst.

3. Verfahren nach Anspruch 2, wobei das Sputtern in einer Gasmischungsatmosphäre durchgeführt wird, die ein inertes Gas beziehungsweise Stickstoff oder Sauerstoff umfasst, bei einem Prozessdruck, so dass der mittlere freie Weg von gesputterten Metallatomen vergleichbar oder größer ist als die Distanz vom Target zum Substrat.

4. Verfahren nach Anspruch 3, wobei die Geometrie des Abscheidungssystems derart ist, dass mindestens ein willkürlicher Bereich auf dem Substrat existiert, wo die Verteilung des abscheidenden Flusses relativ zu der Oberflächennormalen in diesem Bereich asymmetrisch ist.

5. Verfahren nach Anspruch 1, wobei die Metallverbindung mit einer Wurtzit-Struktur ausgewählt ist aus der Gruppe bestehend aus SnO, BN, BeO, AlBN, AlGaN.

6. Verfahren nach einem der Ansprüche 1-5, wobei das Substrat, das eine Oberfläche aufweist für Kristallwachstum mit geneigter c-Achse relativ zu der Oberflächennormalen des Substrats, ausgewählt ist aus der Gruppe bestehend aus
a) einem Substrat mit einer Oberflächenkristallstruktur ohne hexagonale Symmetrie, wie etwa Molybdän, Aluminium, Platin, Wolfram oder Tantal,
b) einem Substrat, das eine Oberflächenkristallstruktur ähnlich der einer beliebigen jeweiligen AlN-Kristallfläche außer der c-Fläche aufweist,
c) einem Substrat, das eine von null verschiedene Oberflächenmikrorauheit aufweist,
d) einem Substrat, auf dem ein sehr dünner polykristalliner Film mit einer Dicke von unter 200 nm und mit einem relativ niedrigen Texturgrad abgeschieden ist,
e) ein Substrat, auf dem ein sehr dünner Film mit einer Dicke von unter 200 nm und einer bevorzugten Nicht-(002)-Textur mit Kreissymmetrie abgeschieden ist, und
f) einem Substrat, auf dem ein willkürlicher, aber sehr dünner amorpher Film mit einer Dicke von unter 200 nm abgeschieden ist und eine von null verschiedene Oberflächenmikrorauheit aufweist.

7. Verfahren nach Anspruch 6, wobei der dünne polykristalline Film in d) und e) ein AlN-Film ist.

8. Verfahren nach Anspruch 6, wobei der dünne polykristalline Film in d) und e) ein ZnO-Film ist.

9. Verfahren nach Anspruch 6, wobei der dünne polykristalline Film in d) und e) ein Wurtzit-Struktur-Metallverbindungsfilm ist.

10. Verfahren nach Anspruch 6, wobei der dünne polykristalline Film in e) durch eine spiralförmige Blende abgeschieden wird, deren Blatt unter einem spezifischen Winkel zu der Mitte des Wafer geneigt ist.

11. Verfahren nach Anspruch 10, wobei die Blende direkt über dem Substrat zentriert ist und mit dem Substrat in einer relativen Rotationsbewegung steht.

12. Verfahren nach Anspruch 6, wobei die Oberfläche mit einer von null verschiedenen Mikrorauheit in c) durch Ätzen oder Polieren erhalten wird.

13. Piezoelektrischer Scherwellen-Resonator, umfassend einen polykristallinen Film aus einer Metallverbindung, ausgewählt aus der Gruppe bestehend aus AlN und ZnO und Wurtzit-Struktur-Metallverbindungen, hergestellt durch das Verfahren nach einem der Ansprüche 1-12.

14. Piezoelektrischer Scherwellen-Resonator nach Anspruch 13, umfassend mindestens zwei Elektroden in der Nähe des Films, um Erregungsmittel bereitzustellen.

15. Piezoelektrischer Scherwellen-Resonator nach Anspruch 13 oder 14 zur Verwendung in einem flüssigen Medium für Massebeladung und/oder Viskositätsmessungen und/oder Druckmessungen.

16. Piezoelektrischer Scherwellen-Resonator nach Anspruch 13 oder 14 zur Verwendung als ein Biosensor und/oder Drucksensor.

17. Piezoelektrischer Scherwellen-Resonator, umfassend einen polykristallinen Film aus einer Metallverbindung mit einer mittleren, von null verschiedenen Neigung der c-Achse relativ zu einer Oberflächennormalen eines Substrats, wobei der Resonator durch das Verfahren nach einem der Ansprüche 1-12 hergestellt wird.

18. Piezoelektrischer Scherwellen-Resonator nach Anspruch 17, wobei der piezoelektrische Film eine ausgeprägte geneigte Textur aufweist, wobei die mittlere Neigung der c-Achse ungefähr im Intervall von 10 bis 50 Grad über dem Substrat variiert.

19. Piezoelektrischer Scherwellen-Resonator nach Anspruch 18, wobei der piezoelektrische Film eine ausgeprägte geneigte Textur aufweist, wobei die mittlere Neigung der c-Achse ungefähr im Intervall von 28 bis 32 Grad über dem Substrat variiert.

20. In-vivo-Drucksensor, umfassend einen piezoelektrischen Scherwellen-Resonator nach Anspruch 15 oder 16 oder nach einem der Ansprüche 1-12 hergestellt.

## Revendications

1. Procédé de fabrication d'un film polycristallin d'un composé métallique choisi dans le groupe constitué par AIN et ZnO et les composés métalliques de structure wurtzite, sur un substrat avec une inclinaison moyenne non nulle de l'axe c par rapport à la normale à la surface du substrat, le substrat comprenant une plaquette de support et ayant une surface pour la croissance de cristaux avec un axe c incliné par rapport à la normale à la surface du substrat,
le procédé comprenant :
i) une étape de nucléation, exécutée en déposant des cristallites dudit composé sur le substrat afin de nucléer des, ou de créer les conditions pour la nucléation de, cônes cristallins avec un axe c incliné par rapport à la normale à la surface, l'étape de nucléation étant exécutée dans des conditions où les atomes pulvérisés subissent des collisions substantielles en phase gazeuse provoquant la thermalisation et la randomisation du flux de dépôt, et
ii) une étape de croissance, exécutée en déposant des atomes du composé métallique sur les cristallites pour obtenir ledit film polycristallin, l'étape de croissance étant exécutée dans des conditions réduisant les collisions en phase gazeuse, faisant que le flux de dépôt en tout point particulier sur le substrat est directionnel.

2. Procédé selon la revendication 1, dans lequel l'étape de croissance est exécutée en faisant fonctionner un système de dépôt conçu pour la pulvérisation d'atomes à partir d'une cible comprenant le métal du composé.

3. Procédé selon la revendication 2, dans lequel ladite pulvérisation est effectuée dans une atmosphère gazeuse mixte comprenant un gaz inerte et de l'azote ou de l'oxygène, respectivement, à une pression de procédé telle que le libre parcours moyen des atomes métalliques pulvérisés est comparable ou plus grand que la distance de la cible au substrat.

4. Procédé selon la revendication 3, dans lequel la géométrie du système de dépôt est telle qu'il existe au moins une zone arbitraire sur le substrat où la distribution du flux de dépôt est asymétrique par rapport à la normale à la surface dans cette zone.

5. Procédé selon la revendication 1, dans lequel le composé métallique ayant une structure wurtzite est choisi dans le groupe constitué par SnO, BN, BeO, AlBN et AlGaN.

6. Procédé selon l'une quelconque des revendications 1 à 5, dans lequel le substrat qui a une surface pour la croissance de cristaux avec un axe c incliné par rapport à la normale à la surface du substrat est choisi dans le groupe constitué par
a) un substrat qui a une structure cristalline superficielle sans symétrie hexagonale, tel que le molybdène, l'aluminium, le platine, le tungstène ou le tantale ;
b) un substrat qui a une structure cristalline superficielle similaire à celle de toute face cristalline particulière de AIN autre que la face c ;
c) un substrat qui a une microrugosité de surface non nulle ;
d) un substrat sur lequel est déposé un film polycristallin très mince, de moins de 200 nm d'épaisseur et avec un degré de texture relativement faible ;
e) un substrat sur lequel est déposé un film polycristallin très mince, de moins de 200 nm d'épaisseur et ayant une texture préférée non-(002) avec une symétrie circulaire ; et
f) un substrat sur lequel est déposé un film amorphe arbitraire, mais très mince, de moins de 200 nm d'épaisseur et ayant une microrugosité de surface non nulle.

7. Procédé selon la revendication 6, dans lequel le film mince polycristallin en d) et e) est un film d'AlN.

8. Procédé selon la revendication 6, dans lequel le film mince polycristallin en d) et e) est un film de ZnO.

9. Procédé selon la revendication 6, dans lequel le film mince polycristallin en d) et e) est un film de composé métallique de structure wurtzite.

10. Procédé selon la revendication 6, dans lequel le film mince polycristallin en e) est déposé par un rideau en forme de spirale dont la lame est inclinée d'un angle spécifique vers le centre de la plaquette.

11. Procédé selon la revendication 10, dans lequel le rideau est centré directement au-dessus du substrat est en mouvement de rotation relatif avec le substrat.

12. Procédé selon la revendication 6, dans lequel la surface à microrugosité non nulle en c) est obtenue par gravure ou polissage.

13. Résonateur piézoélectrique à ondes de cisaillement comprenant un film polycristallin d'un composé métallique choisi dans le groupe constitué par AIN et ZnO et les composés métalliques de structure wurtzite, fabriqué par le procédé selon l'une quelconque des revendications 1 à 12.

14. Résonateur piézoélectrique à ondes de cisaillement selon la revendication 13, comprenant au moins deux électrodes en proximité avec le film pour fournir un moyen d'excitation.

15. Résonateur piézoélectrique à ondes de cisaillement selon la revendication 13 ou 14, pour utilisation dans un milieu liquide pour des mesures de charge massique et/ou de viscosité et/ou des mesures de pression.

16. Résonateur piézoélectrique à ondes de cisaillement selon la revendication 13 ou 14, pour utilisation comme biocapteur et/ou capteur de pression.

17. Résonateur piézoélectrique à ondes de cisaillement comprenant un film polycristallin d'un composé métallique avec une inclinaison moyenne non nulle de l'axe c par rapport à la normale à la surface d'un substrat, le résonateur étant fabriqué par le procédé selon l'une quelconque des revendications 1 à 12.

18. Résonateur piézoélectrique à ondes de cisaillement selon la revendication 17, dans lequel le film piézoélectrique présente une texture inclinée distincte avec l'inclinaison moyenne de l'axe c variant grossièrement dans l'intervalle de 10 à 50 degrés au-dessus du substrat.

19. Résonateur piézoélectrique à ondes de cisaillement selon la revendication 18, dans lequel le film piézoélectrique présente une texture inclinée distincte avec l'inclinaison moyenne de l'axe c variant grossièrement dans l'intervalle de 28 à 32 degrés au-dessus du substrat.

20. Capteur de pression in vivo comprenant un résonateur piézoélectrique à ondes de cisaillement selon la revendication 15 ou 16 ou fabriqué selon l'une quelconque des revendications 1 à 12.
